# EUROPEAN PATENT APPLICATION

(11) **EP 2 448 005 A2**
(43) Date of publication of application: **02.05.2012**
(21) Application number: 11163653.6
(22) Date of filing: 26.04.2011
(51) Int. Cl.: H01L 31/0368, H01L 31/18, H01L 31/0745

(54) **Solar cell and method of making the same**

(30) Priority: 26.10.2010 TW 099136520
(71) Applicant: AU Optronics Corp., Hsin-Chu 300 (TW)
(72) Inventor: Liu, Chee-Wee, Hsin-Chu 300 (TW); Ho, Wei-Shuo, Hsin-Chu 300 (TW); Chen, Yen-Yu, Hsin-Chu 300 (TW); Ku, Chun-Yuan, Hsin-Chu 300 (TW); Wu, Zhen-Cheng, Hsin-Chu 300 (TW); Liang, Shuo-Wei, Hsin-Chu 300 (TW); Chen, Jen-Chieh, Hsin-Chu 300 (TW); Lai, Chung-Wei, Hsin-Chu 300 (TW); Chen, Tsung-Pao, Hsin-Chu 300 (TW)
(74) Representative: Becker Kurig Straus

(57) **Abstract**

A solar cell (10) includes a crystalline semiconductor substrate (12); a first crystalline semiconductor layer (14); an amorphous semiconductor layer (16); a first metal electrode layer (18) and a second metal electrode layer (20). The crystalline semiconductor substrate (12) has a first surface (121) and a second surface (122), and the crystalline semiconductor substrate (12) has a first doped type. The first crystalline semiconductor layer (14) is disposed on the first surface (121) of the crystalline semiconductor substrate (12), where the first crystalline semiconductor layer (14) has a second doped type contrary to the first doped type. The amorphous semiconductor layer (16) is disposed on the first crystalline semiconductor layer (14), and the amorphous semiconductor layer (16) has the second doped type. The first metal electrode layer (18) is disposed on the amorphous semiconductor layer (16). The second metal electrode layer (20) is disposed on the second surface (122) of the crystalline semiconductor substrate (12).

## Description

### Field of the Invention

The present invention is related to a solar cell and a method of making the same according to the pre-characterizing clauses of claims 1 and 9.

### Background of the Invention

Presently, the main energy resource for people to use is petroleum. Because of the limited amount of petroleum, the demand for substitute energy sources increases with times, and among all kinds of substitute energy sources, the most potential one is solar energy.

The conventional solar cell, such as the Heterojunction with Intrinsic Thin-layer (HIT) solar cell, however, is restricted by the difficulties in process control and interface traps, which leads to lower open-circuit voltage. The lower open-circuit voltage of the conventional solar cell constrains the improvement of power conversion efficiency, and adversely affects the progress of solar cell.

### Summary of the Invention

This in mind, the present invention aims at providing a solar cell and a method of making the same so as to achieve high power conversion efficiency.

This is achieved by a solar cell and a method of making the same according to the pre-characterizing clauses of claims 1 and 9. The dependent claims pertain to corresponding further developments and improvements.

As will be seen more clearly from the detailed description following below, the claimed solar cell comprises a crystalline semiconductor substrate; a first crystalline semiconductor layer; an amorphous semiconductor layer; a first metal electrode layer and a second metal electrode layer. The crystalline semiconductor substrate has a first surface and a second surface, and the crystalline semiconductor substrate has a first doped type. The first crystalline semiconductor layer is disposed on the first surface of the crystalline semiconductor substrate, where the first crystalline semiconductor layer has a second doped type contrary to the first doped type. The amorphous semiconductor layer is disposed on the first crystalline semiconductor layer, and the amorphous semiconductor layer has the second doped type. The first metal electrode layer is disposed on the amorphous semiconductor layer. The second metal electrode layer is disposed on the second surface of the crystalline semiconductor substrate.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof
- FIG. 1: illustrates a schematic diagram of a solar cell according to an exemplary embodiment of the present invention,
- FIG. 2-FIG. 4: illustrate schematic diagrams of a method of forming a solar cell according to an exemplary embodiment of the present invention,
- FIG. 5-FIG. 6: illustrate schematic diagrams of a method of forming a solar cell according to another exemplary embodiment of the present invention,
- FIG. 7: is a simulation diagram illustrating a relation between a dark current density and an applied voltage of a solar cell according to an exemplary embodiment of the present invention,
- FIG. 8: is a simulation diagram illustrating a relation between an open-circuit voltage V_{oc} and a thickness X of a first crystalline semiconductor layer of a solar cell according to an exemplary embodiment of the present invention,
- FIG. 9: is a simulation diagram illustrating a relation between a current density J_{sc} and a thickness X of a first crystalline semiconductor layer of a solar cell according to an exemplary embodiment of the present invention, and
- FIG. 10: is a simulation diagram illustrating a relation between a power conversion efficiency and a thickness X of a first crystalline semiconductor layer of a solar cell according to an exemplary embodiment of the present invention.

### Detailed Description

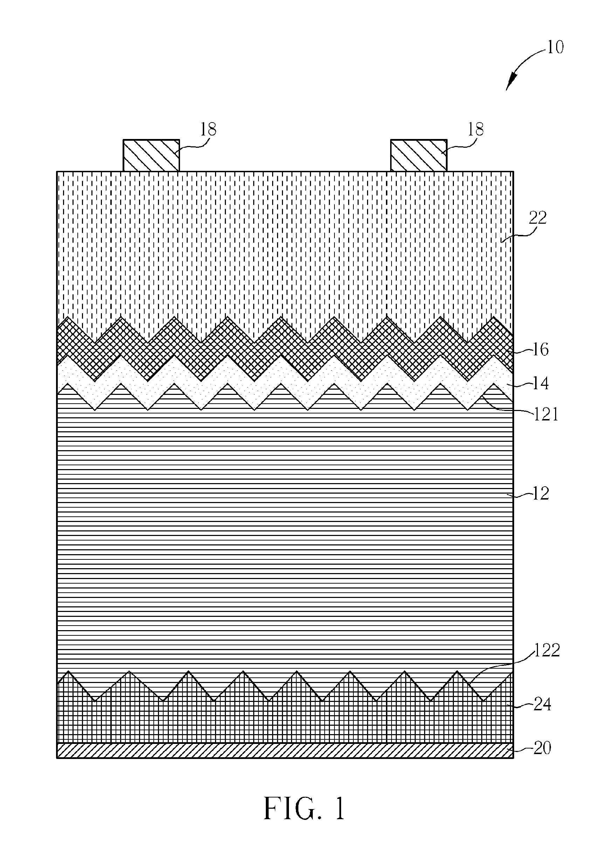

Please refer to FIG. 1. FIG. 1 illustrates a schematic diagram of a solar cell according to an exemplary embodiment of the present invention. As shown in FIG. 1, the solar cell 10 of the exemplary embodiment includes a crystalline semiconductor substrate 12; a first crystalline semiconductor layer 14; an amorphous semiconductor layer 16; a first metal electrode layer 18 and a second metal electrode layer 20. The crystalline semiconductor substrate 12 has a first surface 121 and a second surface 122, and the crystalline semiconductor substrate 12 has a first doped type. The lattice vector of the crystalline semiconductor substrate 12 can be such as (1,0,0), (1,1,0), (1,1,1), etc., but not limited thereto. The crystalline semiconductor substrate 12 may be a wafer, a die or any other types of semiconductor substrates. The first crystalline semiconductor layer 14 is disposed on the first surface 121 of the crystalline semiconductor substrate 12, where the first crystalline semiconductor layer 14 has a second doped type contrary to the first doped type. For instance, in the exemplary embodiment, the first doped type can be P type, while the second doped type is N type, but not limited thereto, or the first doped type can also be N type, while the second doped type is P type. Because of the difference in the doped types between the crystalline semiconductor substrate 12 and the first crystalline semiconductor layer 14, a PN junction occurs in the interface between the crystalline semiconductor substrate 12 and the first crystalline semiconductor layer 14. In this exemplary embodiment, the crystalline semiconductor substrate 12 and the first crystalline semiconductor layer 14 are both made of crystalline semiconductor materials. For example, at least one of the crystalline semiconductor substrate 12 and the first crystalline semiconductor layer 14 is made of single crystalline silicon or poly crystalline silicon. More specifically, the materials of the crystalline semiconductor substrate 12 and the first crystalline semiconductor layer 14 are preferably the same, for example, the crystalline semiconductor substrate 12 and the first crystalline semiconductor layer 14 are both made of single crystalline silicon, or the crystalline semiconductor substrate 12 and the first crystalline semiconductor layer 14 are both made of poly crystalline silicon. The material of the crystalline semiconductor substrate 12 and the material of the first crystalline semiconductor layer 14 can be different, which may lead to inferior power conversion efficiency. Further, the dopant concentration of the crystalline semiconductor substrate 12 may be substantially the same as the dopant concentration of the first crystalline semiconductor layer 14, but not limited thereto. The dopant concentration of the crystalline semiconductor substrate 12 and the dopant concentration of the first crystalline semiconductor layer 14 can be substantially different, which may lead to inferior power conversion efficiency. In this exemplary embodiment, the dopant concentration of the crystalline semiconductor substrate 12 is approximately between 10¹⁴ atoms/cm² and 10¹⁷ atoms/cm², and the dopant concentration of the first crystalline semiconductor layer 14 is approximately between 10¹⁷ atoms/cm² and 10²¹ atoms/cm², but not limited thereto. Moreover, the thickness of the crystalline semiconductor substrate 12 is approximately between 50 micrometer (µm) and 500 µm, but not limited thereto. The thickness of the first crystalline semiconductor layer 14 is approximately larger than 0 nanometer (nm) and less than or equal to 500 nm, for instance, preferably larger than 0 nm and less than or equal to 200 nm, and more preferably about 15 nm, but not limited thereto. The amorphous semiconductor layer 16 is disposed on the first crystalline semiconductor layer 14, and the amorphous semiconductor layer 16 has the second doped type. In this exemplary embodiment, the thickness of the amorphous semiconductor layer 16 is approximately between 1 nm and 20 nm, but not limited thereto. Additionally, the dopant concentration of the amorphous semiconductor layer 16 is higher than the dopant concentration of the first crystalline semiconductor layer 14. In this exemplary embodiment, for instance, the dopant concentration of the amorphous semiconductor layer 16 is substantially between 10¹⁸ atoms/cm² and 10²¹ atoms/cm². The first metal electrode layer 18 is disposed on the amorphous semiconductor layer 16, and the second metal electrode layer 20 is disposed on the second surface 122 of the crystalline semiconductor substrate 12. The first metal electrode layer 18 and the second metal electrode layer 20 may be made of metal with excellent conductivity, such as aluminum (A1), silver (Ag), platinum (Pt), aurum (Au), alloy of above metal elements, or any other suitable materials, but not limited thereto. Furthermore, the thickness, the area and the pattern of the first metal electrode layer 18 and the second metal electrode layer 20 are all adjustable on the basis of requirements.

The solar cell 10 may further include a passivation layer 22 disposed between the amorphous semiconductor layer 16 and the first metal electrode layer 18. The passivation layer 22 may be a single-layered structure or a multi-layered structure. The passivation layer 22 may include, but not limited thereto, transparent conducting material such as Indium Tin Oxide (ITO), Indium Zinc Oxide (IZO), Antimony Tin Oxide (ATO), Aluminum Zinc Oxide (AZO), Indium Gallium Zinc Oxide (IGZO), etc. The thickness of transparent conducting material is, for example, approximately between 10 nm and 500 nm. Also, the material of the passivation layer 22 may also include, but not limited thereto, anti-reflective material such as silicon oxide, silicon nitride, or silicon oxynitride. Furthermore, the passivation layer 22 is necessary to utilize substantially transparent material, because if the passivation layer 22 utilizes opaque material, the solar cell 10 cannot perform energy conversion process. The solar cell 10 of this exemplary embodiment may also include a second semiconductor layer 24 disposed between the crystalline semiconductor substrate 12 and the second metal electrode layer 20. The second semiconductor layer 24 is electrically connected to the crystalline semiconductor substrate 12 and the second metal electrode layer 20 for reducing the contact resistance. If there is no concern about contact resistance, the disposition of the second semiconductor layer 24 is no longer necessary. The material of the second semiconductor layer 24 can include amorphous silicon, and the thickness of second semiconductor layer 24 is approximately between 1 µm and 50 µm, but not limited thereto. Further, the second semiconductor layer 24 has the first doped type, and the dopant concentration of the second semiconductor layer 24 is preferably higher than the dopant concentration of the crystalline semiconductor substrate 12. In this exemplary embodiment, for instance, the dopant concentration of the second semiconductor layer 24 is substantially between 10¹⁷ atoms/cm² and 10²¹ atoms/cm². In this exemplary embodiment, the interface between two adjacent film layers in the solar cell 10 such as the interface between the crystalline semiconductor substrate 12 and the first crystalline semiconductor layer 14, the interface between the first crystalline semiconductor layer 14 and the amorphous semiconductor layer 16, the interface between the crystalline semiconductor substrate 12 and the second semiconductor layer 24 and so on, can alternatively undergo a textured process for increasing the amount of incident light, but not limited thereto. If the power conversion efficiency of the solar cell 10 is high enough, the utilization of the textured process is optional, surely, the additional implementation of textured process induces better power conversion efficiency.

In this exemplary embodiment of the present invention, the PN junction of the solar cell 10 occurs between the crystalline semiconductor substrate 12 and the first crystalline semiconductor layer 14, that is, the depletion region is located in the interface between the crystalline semiconductor substrate 12 and the first crystalline semiconductor layer 14. The homo-junction between the crystalline semiconductor substrate 12 and the first crystalline semiconductor layer 14 is unfavorable for generation of interface traps, while the hetero-junction between the first crystalline semiconductor layer 14 and the amorphous semiconductor layer 16 is favorable for generation of interface traps. However, since the depletion region is far away from the hetero-junction between the first crystalline semiconductor layer 14 and the amorphous semiconductor layer 16, the recombination of electron-hole pairs can be induced. Therefore, the less recombination of electron-hole pairs induces a higher open-circuit voltage of solar cell, and improves the power conversion efficiency.

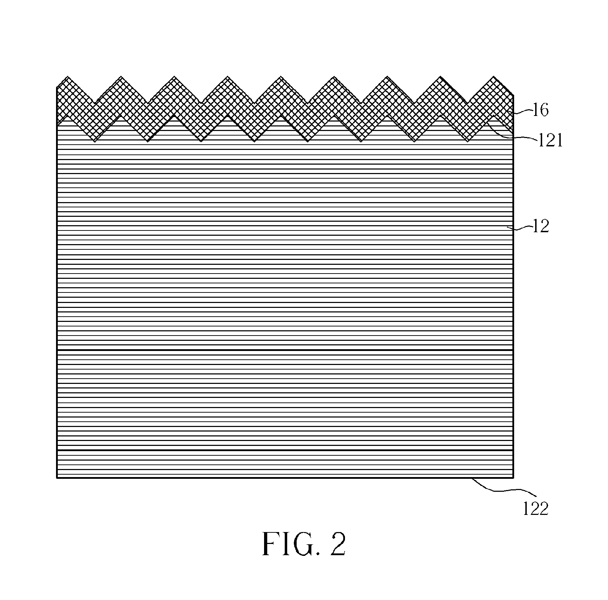

The following paragraphs would detail the methods of forming the solar cell of the present invention. In the following exemplary embodiment, the same components are denoted by the same numerals, and only the differences are discussed while the similarities are not mentioned again. Please refer to FIG. 2- FIG. 4. FIG. 2-FIG. 4 illustrate schematic diagrams of a method of forming a solar cell according to an exemplary embodiment of the present invention. As shown in FIG. 2, at first, a crystalline semiconductor substrate 12 with a first doped type is provided. To increase the amount of incident light, the textured process may be implemented on a first surface 121 of the crystalline semiconductor substrate 12. The textured process also may be omitted as mentioned before. Next, an amorphous semiconductor layer 16 with a second doped type is formed on the first surface 121 of the crystalline semiconductor layer 12.

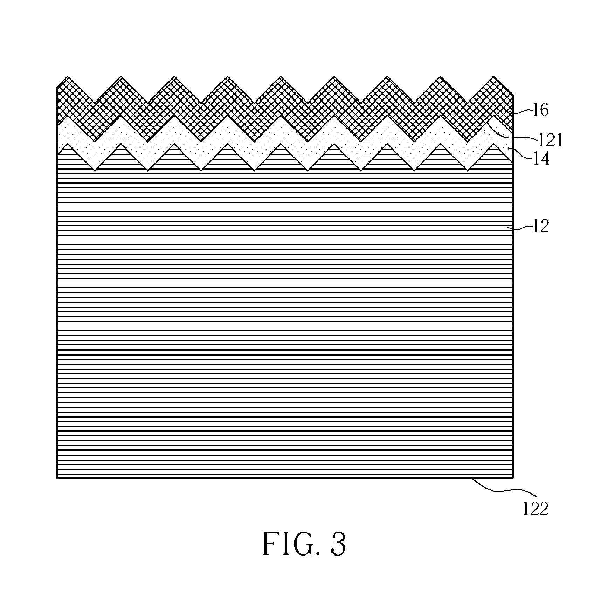

As shown in FIG. 3, an annealing process is then performed to diffuse the dopant of the amorphous semiconductor layer 16 along the direction toward the crystalline semiconductor substrate 12 for forming a first crystalline semiconductor layer 14 in the first surface 121 of the crystalline semiconductor substrate 12. The first crystalline semiconductor layer 14 and the crystalline semiconductor substrate 12 possess the same crystalline type, but contrary doped type. Therefore, a PN junction occurs between the crystalline semiconductor substrate 12 and the first crystalline semiconductor layer 14, i.e. the depletion region is located in the interface between the crystalline semiconductor substrate 12 and the first crystalline semiconductor layer 14.

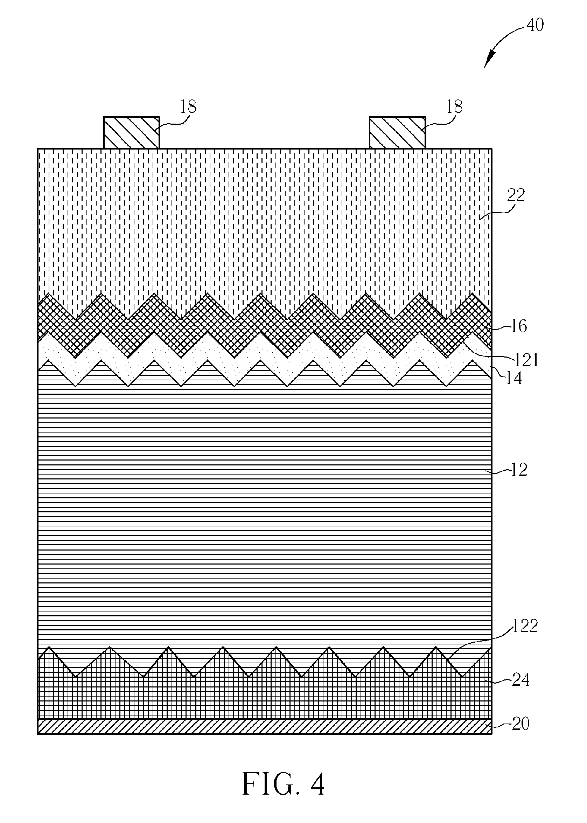

As shown in FIG. 4, a passivation layer 22 may be selectively formed on the amorphous semiconductor layer 16, and further, a first metal electrode layer 18 is formed on the passivation layer 22. Additionally, the textured process may be selectively implemented on a second surface 122 of the crystalline semiconductor substrate 12. Subsequently, a second semiconductor layer 24 is formed on the second surface 122 of the crystalline semiconductor substrate 12, and a second metal electrode layer 20 is formed on the second semiconductor layer 24. Accordingly, the solar cell 40 of this exemplary embodiment is fabricated.

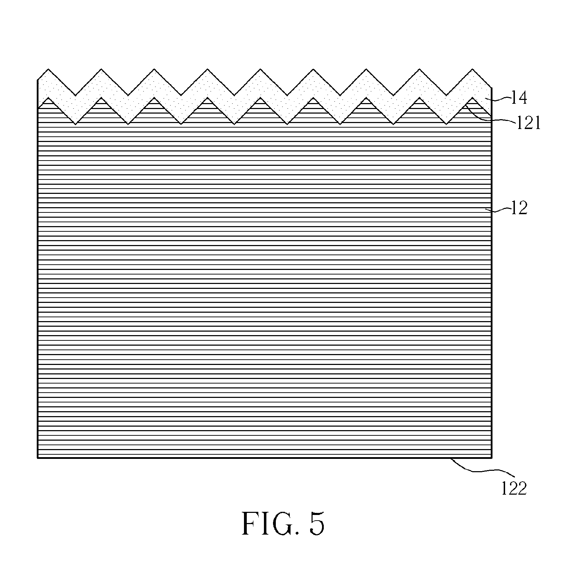

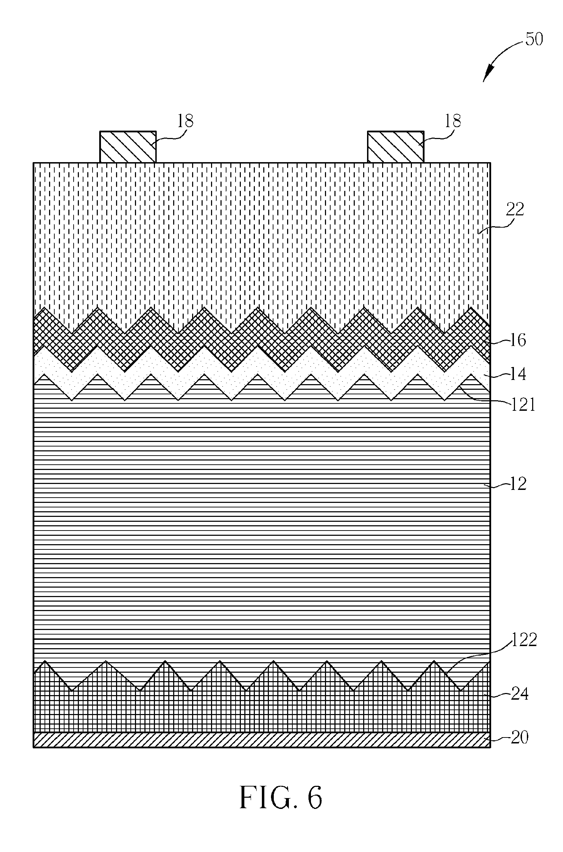

Please refer to FIG. 5―FIG. 6. FIG. 5-FIG. 6 illustrate schematic diagrams of a method of forming a solar cell according to another exemplary embodiment of the present invention. As shown in FIG. 5, at first, a crystalline semiconductor substrate 12 with a first doped type is provided. Next, a first crystalline semiconductor layer 14 with a second doped type contrary to the first doped type is formed on a first surface 121 of the crystalline semiconductor substrate 12. The material of the crystalline semiconductor substrate 12 and the material of the first crystalline semiconductor layer 14 could be the same. Using different materials for the crystalline semiconductor substrate 12 and the material of the first crystalline semiconductor layer 14 is also acceptable; however, the difference might be unfavorable to the energy conversion efficiency.

As shown in FIG. 6, an amorphous semiconductor layer 16 with the second doped type is formed on the first crystalline semiconductor layer 14. Then, a passivation layer 22 is selectively formed on the amorphous semiconductor layer 16, and a first metal electrode layer 18 is formed on the passivation layer 22. Additionally, a second semiconductor layer 24 may be optionally formed on a second surface 122 of the crystalline semiconductor substrate 12, and a second metal electrode layer 20 is formed on the second semiconductor layer 24. Accordingly, the solar cell 50 of this exemplary embodiment is fabricated.

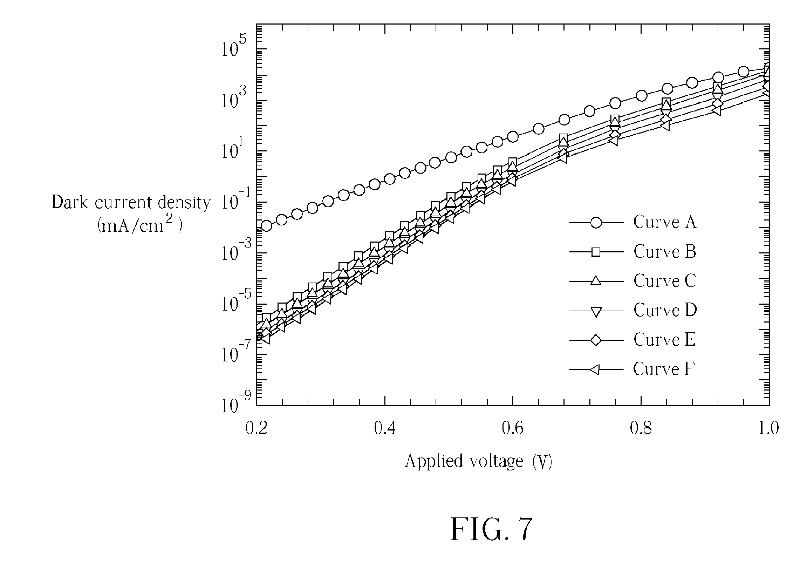

Please refer to FIG. 7. FIG. 7 is a simulation diagram illustrating a relation between a dark current density and an applied voltage of a solar cell according to an exemplary embodiment of the present invention. In this simulation, the interface trap density (Dit) is substantially kept as 5*10¹³ (#/cm²eV); curve A represents the relation between the dark current density and the applied voltage of the solar cell under the condition where the thickness of the first crystalline semiconductor layer is 0 (i.e. the first crystalline semiconductor layer does not exist); and curves B-F represent the relation between the dark current density and the applied voltage of the solar cell under the condition where the thickness of the first crystalline semiconductor layer is 15 nm, 25 nm, 50 nm, 100 nm and 200 nm, respectively. As shown in FIG. 7, without incident light, when the same applied voltage is given, the dark current density (curve B-curve F) of the solar cell having the first crystalline semiconductor layer is obviously lower than the dark current density (curve A) of the solar cell without the first crystalline semiconductor layer. Therefore, the effect of the first crystalline semiconductor layer upon the decrease of dark current density is proven.

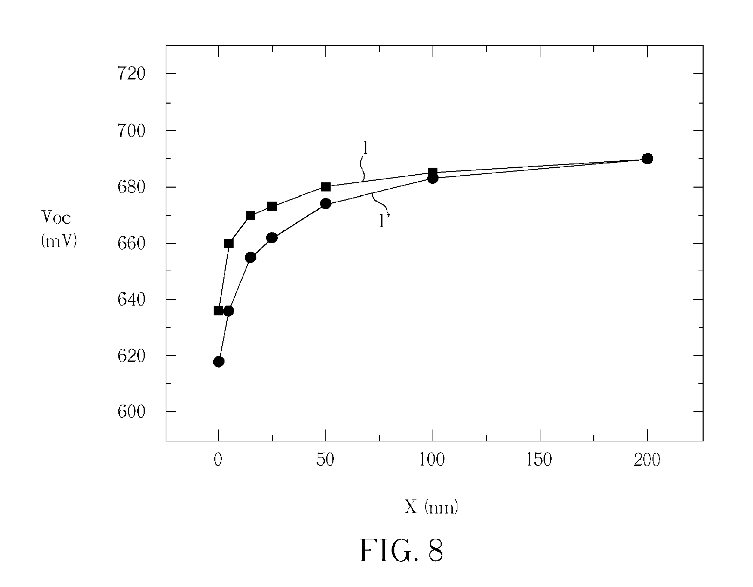

Please refer to FIG. 8. FIG. 8 is a simulation diagram illustrating a relation between an open-circuit voltage V_{oc} and a thickness X of a first crystalline semiconductor layer of a solar cell according to an exemplary embodiment of the present invention. Curve 1 is obtained under the condition where the interface trap density (Dit) is about 2*10¹³(#/cm2eV), and curve 1' is obtained under the condition where the interface trap density is about 2.5^{*}10¹³(#/cm² eV). As shown in FIG. 8, with incident light, when the thickness X of the first crystalline semiconductor layer is approximately larger than 0 nm and less than or equal to 200 nm, the corresponding open-circuit voltage V_{oc} of the solar cell is substantially between 620 mV and 700mV.

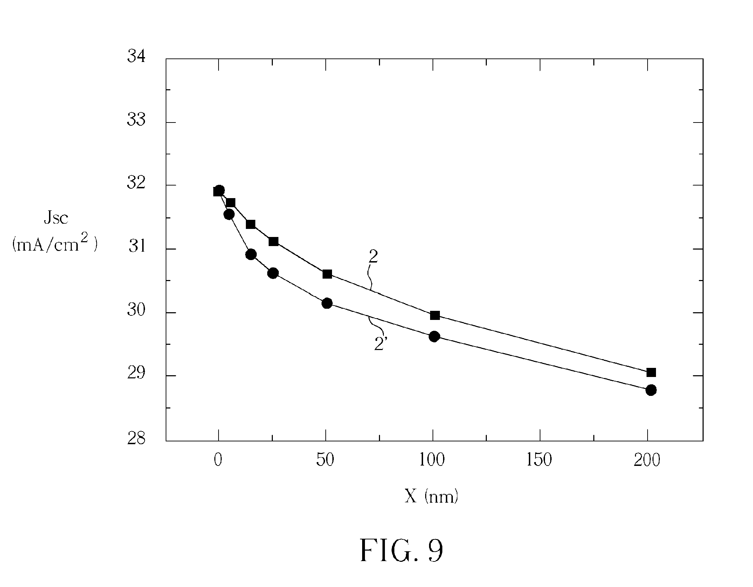

Please refer to FIG. 9. FIG. 9 is a simulation diagram illustrating a relation between a current density J_{sc} and a thickness X of a first crystalline semiconductor layer of a solar cell according to an exemplary embodiment of the present invention. Curve 2 is obtained under the condition where the interface trap density (Dit) is about 2*10¹³(#/cm2eV), and curve 2' is obtained under the condition where the interface trap density is about 2.5*10¹³(#/cm²eV). As shown in FIG. 9, with incident light, when the thickness X of the first crystalline semiconductor layer is approximately larger than 0 nm and less than or equal to 200 nm, the corresponding current density J_{sc} of the solar cell is substantially between 29 mA/cm² and 32 mA/cm².

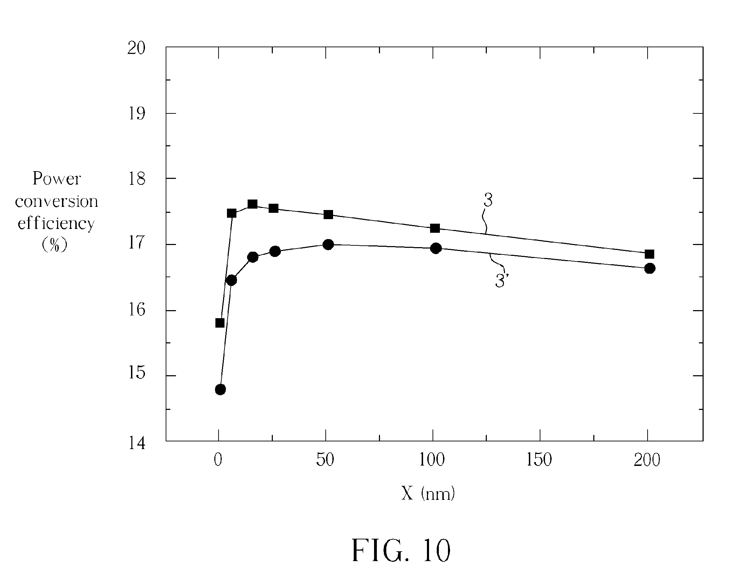

Please refer to FIG. 10. FIG. 10 is a simulation diagram illustrating a relation between a power conversion efficiency and a thickness X of a first crystalline semiconductor layer of a solar cell according to an exemplary embodiment of the present invention. Curve 3 is obtained under the condition where the interface trap density (Dit) is about 2*10¹³(#/cm² eV), and curve 3' is obtained under the condition where the interface trap density is about 2.5*10¹³(#/cm²eV). As shown in FIG. 10, with incident light, when the thickness X of the first crystalline semiconductor layer is approximately larger than 0 nm and less than or equal to 200 nm, the corresponding power conversion efficiency of the solar cell is substantially between 15% and 17.5%. Specifically, as the thickness X of the first crystalline semiconductor layer is between 10 nm and 20 nm, such as about 15nm, the power conversion efficiency of the solar cell reaches to 17.5% substantially.

In conclusion, the depletion region of the solar cell of the present invention is located in the homo-junction interface between the crystalline semiconductor substrate and the first crystalline semiconductor layer, which is away from the hetero-junction between the first crystalline semiconductor layer and the amorphous semiconductor layer. As a result, the recombination of electron-hole pairs can be reduced, the open-circuit voltage of solar cell can be improved, and the power conversion efficiency can be enhanced.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A solar cell (10), comprising:
a crystalline semiconductor substrate (12) having a first surface (121) and a second surface (122), wherein the crystalline semiconductor substrate (12) has a first doped type;
a first metal electrode layer (18); and
a second metal electrode layer (20) disposed on the second surface (122) of the crystalline semiconductor substrate (12);
**characterized by** a first crystalline semiconductor layer (14) disposed on the first surface (121) of the crystalline semiconductor substrate (12), wherein the first crystalline semiconductor layer (14) has a second doped type contrary to the first doped type; and an amorphous semiconductor layer (16) disposed on the first crystalline semiconductor layer (14), wherein the amorphous semiconductor layer (16) has the second doped type, and the amorphous semiconductor layer (16) is disposed between the first metal electrode layer (18) and the first crystalline semiconductor layer (14).

2. The solar cell (10) of claim 1, **characterized in that** a material of at least one of the crystalline semiconductor substrate (12) and the first crystalline semiconductor layer (14) comprises single crystalline silicon or poly crystalline silicon.

3. The solar cell (10) of claim 1, **characterized in that** a thickness of the first crystalline semiconductor layer (14) is substantially smaller than 500 nanometer (nm).

4. The solar cell (10) of claim 1, **characterized in that** a thickness of the amorphous semiconductor layer (16) is substantially between 1 nm and 20 nm.

5. The solar cell (10) of claim 1, **characterized in that** a dopant concentration of the amorphous semiconductor layer (16) is substantially higher than a dopant concentration of the first crystalline semiconductor layer (14).

6. The solar cell (10) of claim 1, **characterized in that** the solar cell (10) further comprises a second semiconductor layer (24) disposed between the crystalline semiconductor substrate (12) and the second metal electrode layer (20), wherein the second semiconductor layer (24) is electrically connected to the crystalline semiconductor substrate (12) and the second metal electrode layer (20), the second semiconductor layer (24) has the first doped type, and a dopant concentration of the second semiconductor layer (24) is substantially higher than a dopant concentration of the crystalline semiconductor substrate (12).

7. The solar cell (10) of claim 6, **characterized in that** a material of the second semiconductor layer (24) comprises amorphous silicon.

8. The solar cell (10) of claim 1, **characterized in that** the solar cell (10) further comprises a passivation layer (22) disposed between the amorphous semiconductor layer (16) and the first metal electrode layer (18).

9. A method of forming a solar cell (10), comprising:
providing a crystalline semiconductor substrate (12), wherein the crystalline semiconductor substrate (12) has a first doped type;
forming a first metal electrode layer (18); and
forming a second metal electrode layer (20) on a second surface (122) of the crystalline semiconductor substrate (12);
**characterized by** forming a first crystalline semiconductor layer (14) on a first surface (121) of the crystalline semiconductor substrate (12) prior to forming the first metal electrode layer (18), wherein the first crystalline semiconductor layer (14) has a second doped type contrary to the first doped type; and forming an amorphous semiconductor layer (16) on the first crystalline semiconductor layer (14) prior to forming the first metal electrode layer (18), wherein the amorphous semiconductor layer (16) has the second doped type.

10. The method of forming the solar cell (10) of claim 9, **characterized in that** steps of forming the first crystalline semiconductor layer (14) on the first surface (121) of the crystalline semiconductor substrate (12) comprise:
forming the amorphous semiconductor layer (16) on the first surface (121) of the crystalline semiconductor substrate (12); and
performing an annealing process to form the first crystalline semiconductor layer (14) in the crystalline semiconductor substrate (12).

11. The method of forming the solar cell (10) of claim 9, **characterized in that** a material of at least one of the crystalline semiconductor substrate (12) and the first crystalline semiconductor layer (14) comprises single crystalline silicon or poly crystalline silicon.

12. The method of forming the solar cell (10) of claim 9, **characterized in that** a dopant concentration of the amorphous semiconductor layer (16) is substantially higher than a dopant concentration of the first crystalline semiconductor layer (14).

13. The method of forming the solar cell (10) of claim 9, **characterized in that** the method further comprises forming a second semiconductor layer (24) between the crystalline semiconductor substrate (12) and the second metal electrode layer (20), wherein the second semiconductor layer (24) has the first doped type, and a dopant concentration of the second semiconductor layer (24) is substantially higher than a dopant concentration of the crystalline semiconductor substrate (12).

14. The method of forming the solar cell (10) of claim 13, **characterized in that** a material of the second semiconductor layer (24) comprises amorphous silicon.

15. The method of forming the solar cell (10) of claim 9, **characterized in that** the method further comprises forming a passivation layer (22) between the amorphous semiconductor layer (16) and the first metal electrode layer (18).
